# EUROPÄISCHE PATENTSCHRIFT

(11) **EP 3 599 690 B1**
(45) Veröffentlichungstag und Bekanntmachung des Hinweises auf die Patenterteilung: **24.11.2021**
(21) Anmeldenummer: 19020128.5
(22) Anmeldetag: 15.03.2019
(51) Int. Cl.: H02H 3/33, H02H 3/17, H02H 9/08, H02J 7/00

(54) **VERFAHREN UND VORRICHTUNG ZUR REDUKTION VON ABLEITSTRÖMEN**
METHOD AND DEVICE FOR REDUCTION OF LEAKAGE CURRENTS
PROCÉDÉ ET DISPOSITIF DE RÉDUCTION DES COURANTS DE FUITE

(30) Priorität: 27.07.2018 DE 102018118259
(43) Veröffentlichungstag der Anmeldung: 29.01.2020
(73) Patentinhaber: Dr. Ing. h.c. F. Porsche AG, 70435 Stuttgart (DE)
(72) Erfinder: Spesser, Daniel, 75428 Illingen (DE); Pfizenmaier, Tim, 71229 Leonberg (DE)

(56) Entgegenhaltungen:
- EP-A1- 2 372 857
- DE-A1- 10 139 028
- DE-A1-102008 024 348
- FR-A1- 3 013 848

## Beschreibung

Die Erfindung betrifft ein Verfahren zur Reduktion von Ableitströmen in einem Schutzleiter eines Stromnetzes, welches zusätzlich zu dem Schutzleiter einen Neutralleiter und einen Phasenleiter umfasst. Ein weiterer Gegenstand der Erfindung ist eine Vorrichtung zur Durchführung eines derartigen Verfahrens.

Insbesondere in Stromnetzen, an denen Stromrichter ohne galvanische Trennung, d.h. ohne Trenntransformator, angeschlossen sind, kann es zu durch den Stromrichter hervorgerufenen Ableitströmen in dem Schutzleiter des Stromnetzes kommen. Übersteigt der Ableitstrom einen vorgegebenen Wert, führt dies in der Regel dazu, dass ein Fehlerstrom-Schutzschalter (engl. residual current device, RCD) auslöst und den Stromfluss unterbricht. Der Fehlerstrom-Schutzschalter kann dabei nicht zwischen solchen betriebsbedingten, d.h. beispielsweise durch einen Stromrichter hervorgerufenen, Ableitströmen und Ableitströmen unterscheiden, die durch einen Isolationsfehler hervorgerufen werden. Daher kommt es zu unerwünschten Abschaltungen, welche die Verfügbarkeit des Stromnetzes bzw. des Stromrichters einschränken.

Aus der US 2014 210 411 A1 ist ein Verfahren zur Reduktion von Ableitströmen in einem Schutzleiter eines Stromnetzes bekannt, bei welchem mittels einer passiven Kompensationsschaltung ein Kompensationsstrom erzeugt und zur Kompensation von Ableitströmen in den Schutzleiter eingeleitet wird. Die Kompensationsschaltung umfasst einen Transformator, einen Dioden-Gleichrichter und einen Spannungsteiler und ist galvanisch mit dem Schutzleiter verbunden. Bei diesem Verfahren hat es sich als nachteilig herausgestellt, dass die entsprechende Kompensationsschaltung einen relativ großen Bauraum einnimmt und ein hohes Gesicht aufweist, so dass sie zur Anwendung an Bord eines Fahrzeugs nur unzureichend geeignet ist.

Aus der FR 3 013 848 A1 ist weiterhin ein elektrisches Gerät zum sicheren Austausch elektrischer Energie zwischen einem Verbraucher eines Stromkreises eines Fahrzeugs und einer elektrischen Quelle eines elektrischen Netzes außerhalb des Fahrzeugs bekannt. In der DE 10 2008 024 348 A1 wird ein Verfahren zur Reduktion pulsförmiger Endströme in einer Netzanschlussleitung eines einphasigen oder mehrphasigen Systems beschrieben. Die EP 2 372 857 A1 behandelt ein Verfahren zur Bestimmung eines Fehlerstromanteils eines Differenzstroms und aus der DE 101 39 028 A1 ist ein Verfahren zum Kompensieren eines Ableitstroms bekannt.

Vor diesem Hintergrund ist stellt sich die Aufgabe, die Reduktion unerwünschter Ableitströme in einem Stromnetz mit Neutralleiter mit einer kompakten Kompensationsschaltung zu ermöglichen, die ein geringeres Gewicht.aufweist.

Zur Lösung der Aufgabe wird ein Verfahren nach Anspruch 1 vorgeschlagen.

Bei dem erfindungsgemäßen Verfahren wird der Ableitstrom in dem Schutzleiter nicht direkt gemessen, sondern indirekt bestimmt, indem ein dem Ableitstrom entsprechender Differenzstrom ermittelt wird. Dieser Differenzstrom wird als Differenz der Ströme in dem Phasenleiter und dem Neutralleiter ermittelt. In Abhängigkeit von dem ermittelten Differenzstrom wird ein Kompensationsstrom erzeugt und in den Phasenleiter und/oder in den Neutralleiter eingespeist. Die Messung und die Kompensation des Ableitstroms kann somit ohne galvanische Verbindung mit dem Schutzleiter erfolgen, weshalb eine galvanische Trennung in der entsprechenden Kompensationsschaltung, beispielsweise durch einen Transformator, nicht erforderlich ist. Hierdurch kann die Kompensationsschaltung kompakt und mit geringem Gewicht ausgeführt werden.

Gemäß einer vorteilhaften Ausgestaltung der Erfindung wird der Differenzstrom mittels eines Differenzstromwandlers ermittelt. Der Differenzstromwandler kann einen Messaufnehmer, insbesondere nach Art eines Zangenamperemeters, aufweisen, welcher den Phasenleiter und den Neutralleiter umschließt. Eine galvanische Verbindung ist nicht erforderlich, so dass die Ermittlung des Differenzstroms berührungslos erfolgen kann. Über den Differenzstromwandler wird bevorzugt der Differenzstrom ermittelt, der sich durch die vektorielle Summe der in dem Phasenleiter und dem Neutralleiter fließenden Ströme mit unterschiedlichen Stromrichtungen ergibt. Der Schutzleiter wird bei einer derartigen Messung mittels eines Differenzstromwandlers nicht durch den Differenzstromwandler geführt.

Eine vorteilhafte Ausgestaltung sieht vor, dass der ermittelte Differenzstrom mittels eines Analog-Digital-Wandlers in einen digitalen Differenzstrom gewandelt wird. Die Bereitstellung eines digitalen Differenzstroms ermöglicht die digitale Verarbeitung des ermittelten Differenzstroms beispielsweise in einem Mikrocontroller oder einem digitalen Filter. Auf diese Weise kann der für die Kompensationsschaltung erforderliche Bauraum weiter verringert werden und die Störanfälligkeit der Kompensationsschaltung reduziert werden.

Erfindungsgemäß wird der Kompensationsstrom in Abhängigkeit von dem ermittelten Differenzstrom und einer vorgegebenen Phasenverschiebung erzeugt. Besonders bevorzugt ist der Betrag des Kompensationsstroms identisch mit dem Betrag des Differenzstroms. Die vorgegebene Phasenverschiebung beträgt bevorzugt 180°.

Erfindungsgemäß ist vorgesehen, dass ein Frequenzspektrum des ermittelten Differenzstroms ermittelt wird. Durch die Ermittlung des Frequenzspektrums können dominante spektrale Anteile in dem Differenzstrom erkannt und der Kompensationsstrom entsprechend dieser spektralen Anteile erzeugt werden. Als besonders vorteilhaft hat es sich erwiesen, wenn das Frequenzspektrum des ermittelten Differenzstroms in einem Frequenzbereich von 20 Hz bis 300 kHz ermittelt wird. Zur Ermittlung des Frequenzspektrums kann eine Fourier-Transformation, insbesondere eine Fast-Fourier-Transformation (FFT) verwendet werden. Alternativ kann das Frequenzspektrum mittels eines P-Burg-Algorithmus oder eines trigonometrischen Algorithmus bestimmt werden.

Erfindungsgemäß wird der Kompensationsstrom in Abhängigkeit von dem ermittelten Frequenzspektrum und einer vorgegebenen Phasenverschiebung erzeugt. Die vorgegebene Phasenverschiebung beträgt bevorzugt 180°.

Der Kompensationsstrom kann mittels eines Digital-Analog-Wandlers oder mittels eines Verstärkers ausgegeben werden, insbesondere mittels eines Rail-to-Rail (R2R)-Verstärkers oder eines Klasse-D-Verstärkers.

Bevorzugt wird der Kompensationsstrom über eine kapazitive Kopplung in den Phasenleiter und/oder den Neutralleiter eingespeist, sodass eine galvanische Kopplung mit dem Schutzleiter nicht erforderlich ist.

Gemäß einer alternativen, bevorzugten Ausgestaltung wird der Kompensationsstrom über eine induktive Kopplung in den Phasenleiter und/oder den Neutralleiter eingespeist.

Gemäß einer weiteren, alternativen bevorzugten Ausgestaltung wird der Kompensationsschaltung über eine galvanische Kopplung in den Phasen weiter und/oder den Neutralleiter eingespeist.

Zur Lösung der eingangs genannten Aufgabe trägt ferner eine Vorrichtung gemäß Anspruch 7 bei.

Ein weiterer Gegenstand der Erfindung ist eine Ladevorrichtung zum Laden eines elektrischen Energiespeichers mit einem Stromnetz und einer vorstehend beschriebenen Vorrichtung.

Bei der Vorrichtung zur Reduktion von Ableitströmen und der Ladevorrichtung können dieselben vorteilhaften Wirkungen erreicht werden wie sie bereits im Zusammenhang mit dem erfindungsgemäßen Verfahren beschrieben worden sind.

Gemäß einer vorteilhaften Ausgestaltung der Ladevorrichtung ist vorgesehen, dass diese als galvanisch nicht-getrennte Ladevorrichtung ausgestaltet ist.

Alternativ oder zusätzlich können bei der Vorrichtung bzw. der Ladevorrichtung auch die im Zusammenhang mit dem erfindungsgemäßen Verfahren beschriebenen vorteilhaften Ausgestaltungen und Merkmale allein oder in Kombination Anwendung finden.

Weitere Einzelheiten und Vorteile der Erfindung sollen nachfolgend anhand der in den Figuren gezeigten Ausführungsbeispiele erläutert werden. Hierin zeigt:
- Fig. 1: eine Vorrichtung zur Reduktion von Ableitströmen in einem Schutzleiter eines Stromnetzes in einer schematischen Darstellung; und
- Fig. 2: ein Ablaufdiagramm eines Ausführungsbeispiels eines erfindungsgemäßen Verfahrens zur Reduktion von Ableitströmen.

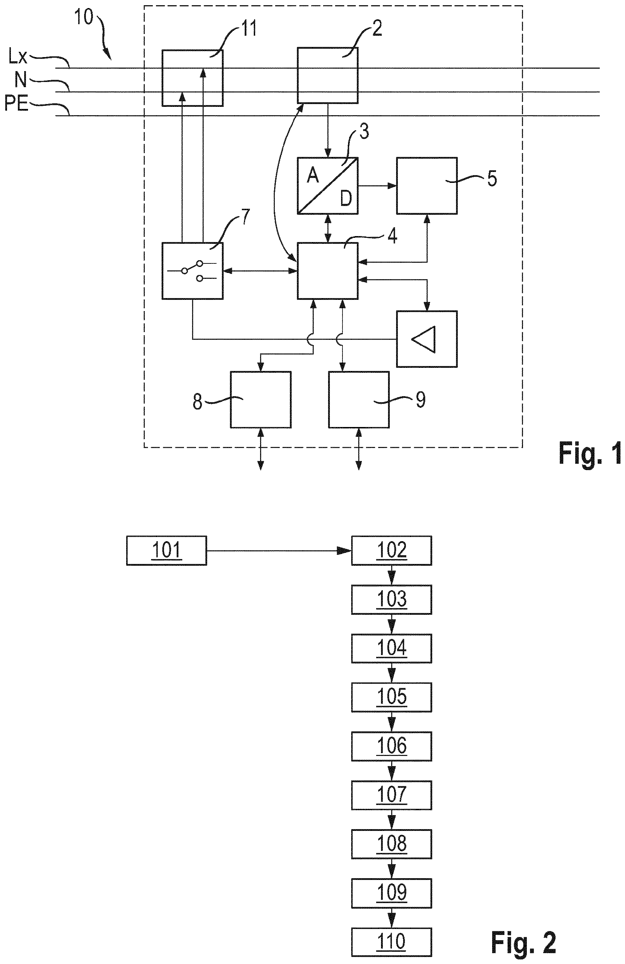

Die Darstellung in Fig. 1 zeigt ein Stromnetz 10 mit einem Phasenleiter LX, einem Neutralleiter N und einem Schutzleiter PE. Dieses Stromnetz 10 kann beispielsweise ein Versorgungsnetz sein, welches an eine Ladevorrichtung zum Laden eines elektrischen Energiespeichers eines Fahrzeugs, insbesondere eines Elektro- oder Hybridfahrzeugs, angeschlossen ist. Bei der Ladevorrichtung handelt es sich bevorzugt um eine galvanisch nicht-getrennte \

Ladevorrichtung. Das Stromnetz 10 ist mit einer Vorrichtung 1 zur Reduktion von Ableitströmen in dem Schutzleiter SE verbunden, die nachfolgend im Einzelnen erläutert werden soll:
Die Vorrichtung 1 weist eine als Differenzstromwandler 2 ausgebildete Ermittlungseinrichtung zur Ermittlung eines Differenzstroms auf, welche den Phasenleiter Lx und den Neutralleiter N insbesondere kontinuierlich überwacht. Insofern werden der Phasenleiterstrom in dem Phasenleiter Lx und der Neutralleiterstrom in dem Neutralleiter N gemessen und die Differenz dieser beiden Ströme gebildet. Der auf diese Weise ermittelte Differenzstrom entspricht dem Ableitstrom in dem Schutzleiter SE. Es ist daher nicht erforderlich, den Schutzleiter SE unmittelbar mit einem Strommesser zu überwachen.

Ein weiterer Bestandteil der Vorrichtung 1 ist ein Analog-Digital-Wandler 3, welcher mit dem Differenzstromwandler 2 verbunden ist. Mittels des Analog-Digital-Wandlers 3 wird der analoge Differenzstrom in einen digitalen Differenzstrom gewandelt. Der-Digitalwandler 3 ist mit einer Recheneinheit 4 verbunden, welche beispielsweise als Mikrocontroller ausgebildet sein kann. Mittels der Recheneinheit 4 wird ein Frequenzspektrum des Differenzstroms ermittelt. Hierzu kann beispielsweise eine Fast-Fourier-Transformation durchgeführt werden. Optional kann alternativ oder zusätzlich eine Analysevorrichtung 5 vorgesehen sein, welche mit dem Analog-Digitalwandler 3 verbunden ist. Die Analysevorrichtung 5 ist dazu eingerichtet, ein Frequenzspektrum des Differenzstroms zu erzeugen. Falls eine solche Analysevorrichtung 5 vorgesehen ist, ist es nicht erforderlich, Berechnungen zur Erzeugung des Frequenzspektrums in der Recheneinheit 4 vorzunehmen. Hierdurch kann die Recheneinheit 4 entlastet werden.

Bevorzugt wird das Frequenzspektrum in einem Bereich von 20 Hz bis 300 kHz ermittelt. Das Frequenzspektrum enthält Amplituden der jeweiligen Frequenzen.

Die Recheneinheit 4 erzeugt anhand des Frequenzspektrums sowie einer vorgegebenen Phasenverschiebung, hier 180°, ein unverstärktes Kompensationsstrom-Signal, welches einem Verstärker 6 der Vorrichtung 1 zugeführt wird. Der Verstärker 6 ist bevorzugt als Rail-to-Rail-Verstärker oder als Klasse-D-Verstärker ausgeführt. Anstelle eines Verstärkers 6 kann alternativ ein Digital-Analog-Wandler verwendet werden. Der Verstärker 6 bzw. der Digital-Analog-Wandler erzeugt einen Kompensationsstrom, der eine Schaltvorrichtung 7 zugeführt wird. Über die Schaltvorrichtung 7 erfolgt eine selektive Ankopplung des Kompensationsstroms an den Phasenleiter LX und/oder den Neutralleiter N.

Der Kompensationsstrom wird über eine kapazitive oder eine induktive Einspeiseeinrichtung 11 in den Phasenleiter und/oder den Neutralleiter eingespeist, sodass eine galvanische Kopplung mit dem Schutzleiter nicht erforderlich ist. Alternativ kann die Einspeisung in den Phasenleiter und/oder den Neutralleiter mittels einer galvanisch angebundenen Einspeiseeinrichtung erfolgen.

Bevorzugt ist die Recheneinheit 4 dazu konfiguriert, betriebsbedingte Ableitströme, wie sie beispielsweise durch eine galvanisch nicht von dem Stromnetz 10 getrennte Ladevorrichtung hervorgerufen werden können, von unerwünschten Fehlerströmen in dem Schutzleiter PE zu unterscheiden. Die Recheneinheit 4 ermittelt und speichert ein charakteristisches Frequenzspektrum, welches durch betriebsbedingte Ableitströme erzeugt wird. Bevorzugt ist die Recheneinheit dazu konfiguriert, ein während der kontinuierlichen Überwachung des Differenzstroms ermitteltes Frequenzspektrum mit dem gespeicherten, charakteristischen Frequenzspektrum zu vergleichen. Falls die Abweichung des ermittelten Frequenzspektrums von dem gespeicherten, charakteristischen Frequenzspektrum einen vorgegebenen Schwellenwert übersteigt, kann ein Schaltsignal zur Ansteuerung der Schaltvorrichtung 7 erzeugt werden. Ein Überschreiten dieses Schwellenwerts deutet auf einen unerwünschten Fehlerstrom hin. In einem solchen Fall wird die Schaltvorrichtung 7 durch das Schaltsignal derart angesteuert, dass ein Kompensationsstrom nicht in den Phasenleiter Lx und/oder den Neutralleiter N eingespeist wird. Dies hat zur Folge, dass der Ableitstrom in dem Schutzleiter PE nicht kompensiert wird und eine in der Zeichnung nicht dargestellte Fehlerstromschutzeinrichtung durch den Fehlerstrom aktiviert werden kann, um das Stromnetz 10 abzuschalten.

Weitere Bestandteile der Vorrichtung 1 sind eine Diagnosevorrichtung 8 zur Erfassung von statistischen Daten, welche über eine Diagnoseschnittstelle ausgelesen werden können, und eine Programmiervorrichtung 9, über welche die Recheneinheit 4 programmiert werden kann. Über die Programmiervorrichtung 9 ist es beispielsweise möglich, Betriebsparameter der Recheneinheit 4 einzustellen.

In der Recheneinheit 4 ist ferner eine Selbstkalibrierung implementiert, welche beim Start der Recheneinheit 4 ausgeführt wird.

Anhand des in Fig. 2 gezeigten Ablaufdiagramms soll nachfolgend ein Verfahrensablauf 100 beim Starten der Recheneinheit 4 näher erläutert werden. In einem Aktivierungsschritt 101 wird die Vorrichtung 1 eingeschaltet. In einem Aktivierungsschritt 101 nachfolgenden Selbsttestschritt 102 wird ein Selbsttest der Vorrichtung 1 gestartet. In einem Schritt 103 wird die Funktionsfähigkeit des Differenzstromwandlers 2 überprüft. In einem Schritt 104 wird die Funktionsfähigkeit des Analog-Digital-Wandlers 3 überprüft. In Schritt 105 wird die Funktionsfähigkeit der Recheneinheit 4 überprüft und in dem Schritt 106 erfolgt eine Überprüfung der Funktionsfähigkeit des Verstärkers 6. In einem Schritt 107 wird die Funktionsfähigkeit eines Watchdogs der Recheneinheit 4 geprüft. In Schritt 108 erfolgt ein Test der Diagnosevorrichtung 8 und in Schritt 109 ein Test einer Selbstkalibrierungsprozedur.

Falls alle Überprüfungen positiv abgeschlossen werden, wird die Vorrichtung in Schritt 110 in einen Betriebszustand überführt. In dem Betriebszustand 110 wird der Differenzstrom in Abhängigkeit von dem Phasenleiterstrom in den Phasenleiter Lx und dem Neutralleiterstrom in den Neutralleiter N ermittelt und in den Phasenleiter Lx und/oder in den Neutralleiter N wird ein Kompensationsstrom eingespeist, welcher einen durch den Differenzstrom hervorgerufenen Ableitungsstrom kompensiert.

### Bezugszeichenliste:

- 1: Vorrichtung zur Reduktion von Ableitströmen
- 2: Differenzstromwandler
- 3: Analog-Digital-Wandler
- 4: Recheneinheit
- 5: Analyseeinheit
- 6: Verstärker
- 7: Schaltvorrichtung
- 8: Diagnosevorrichtung
- 9: Programmiervorrichtung
- 10: Stromnetz
- 11: Einspeiseeinrichtung

- 100: Verfahrensablauf
- 102-109: Testschritte
- 110: Betriebszustand

- Lx: Phasenleiter
- N: Neutralleiter
- PE: Schutzleiter

## Patentansprüche

1. Verfahren zur Reduktion von Ableitströmen in einem Schutzleiter (PE) eines Stromnetzes (10), welches zusätzlich zu dem Schutzleiter (PE) einen Neutralleiter (N) und einen Phasenleiter (Lx) umfasst, wobei ein Differenzstrom in Abhängigkeit von einem Phasenleiterstrom in dem Phasenleiter (Lx) und einem Neutralleiterstrom in dem Neutralleiter (N) ermittelt wird und in den Phasenleiter (Lx) und/oder in den Neutralleiter (N) ein Kompensationsstrom eingespeist wird, welcher einen durch den Differenzstrom hervorgerufenen Ableitstrom kompensiert, dadurch charakterisiert, dass ein Frequenzspektrum des ermittelten Differenzstroms ermittelt und der Kompensationsstrom in Abhängigkeit von dem ermittelten Frequenzspektrum und einer vorgegebenen Phasenverschiebung erzeugt wird.

2. Verfahren nach Anspruch 1, **dadurch gekennzeichnet, dass** der Differenzstrom mittels eines Differenzstromwandlers (2) ermittelt wird.

3. Verfahren nach einem der vorhergehenden Ansprüche, **dadurch gekennzeichnet, dass** der ermittelte Differenzstrom mittels eines Analog-Digital-Wandlers (3) in einen digitalen Differenzstrom gewandelt wird.

4. Verfahren nach einem der vorhergehenden Ansprüche, **dadurch gekennzeichnet, dass** der Kompensationsstrom über eine kapazitive Kopplung eingespeist wird.

5. Verfahren nach einem der Ansprüche 1 bis 3, **dadurch gekennzeichnet, dass** der Kompensationsstrom über eine induktive Kopplung eingespeist wird.

6. Verfahren nach einem der Ansprüche 1 bis 3, **dadurch gekennzeichnet, dass** der Kompensationsstrom über eine galvanische Kopplung eingespeist wird.

7. Vorrichtung zur Reduktion von Ableitströmen in einem Schutzleiter (PE) eines Stromnetzes (10), welches zusätzlich zu dem Schutzleiter (PE) einen Neutralleiter (N) und einen Phasenleiter (Lx) umfasst, wobei die Vorrichtung (1)
-- eine Ermittlungseinrichtung (2) zur Ermittlung eines Differenzstroms in Abhängigkeit von einem Phasenleiterstrom in dem Phasenleiter (Lx) und einem Neutralleiterstrom in dem Neutralleiter (N) aufweist,
**dadurch gekennzeichnet, dass** die Vorrichtung zusätzlich aufweist:
-- eine Recheneinheit (4) zur Ermittlung eines Frequenzspektrums des Differenzstroms,
-- einen mit der Recheneinheit (4) verbundenen Verstärker (6) oder einen mit der Recheneinheit (4) verbundenen Digital-Analog-Wandler zur Erzeugung eines Kompensationsstroms aus einem von der Recheneinheit (4) anhand des ermittelten Frequenzspektrums sowie einer vorgegebenen Phasenverschiebung erzeugten unverstärkten Kompensationsstrom-Signals und
-- eine Einspeiseeinrichtung (11) zum Einspeisen des Kompensationsstroms in den Phasenleiter (Lx) und/oder in den Neutralleiter (N) aufweist, welcher einen durch den Differenzstrom hervorgerufenen Ableitstrom kompensiert.

8. Ladevorrichtung zum Laden eines elektrischen Energiespeichers mit einem Stromnetz (10) und einer Vorrichtung nach Anspruch 7.

9. Ladevorrichtung nach Anspruch 8, **dadurch gekennzeichnet, dass** die Ladevorrichtung als galvanisch nicht-getrennte Ladevorrichtung ausgestaltet ist.

## Claims

1. Method for reducing leakage currents in a protective conductor (PE) of an electricity network (10) comprising a neutral conductor (N) and a phase conductor (Lx) in addition to the protective conductor (PE), wherein a differential current is determined depending on a phase conductor current in the phase conductor (Lx) and a neutral conductor current in the neutral conductor (N) and a compensation current is fed into the phase conductor (Lx) and/or into the neutral conductor (N), said compensation current compensating for a leakage current caused by the differential current, **characterized in that** a frequency spectrum of the differential current determined is determined and the compensation current is generated depending on the frequency spectrum determined and a predefined phase shift.

2. Method according to Claim 1, **characterized in that** the differential current is determined by means of a differential current converter (2).

3. Method according to either of the preceding claims, **characterized in that** the differential current determined is converted into a digital differential current by means of an analogue-to-digital converter (3).

4. Method according to any of the preceding claims, **characterized in that** the compensation current is fed in via a capacitive coupling.

5. Method according to any of Claims 1 to 3, **characterized in that** the compensation current is fed in via an inductive coupling.

6. Method according to any of Claims 1 to 3, **characterized in that** the compensation current is fed in via a galvanic coupling.

7. Device for reducing leakage currents in a protective conductor (PE) of an electricity network (10) comprising a neutral conductor (N) and a phase conductor (Lx) in addition to the protective conductor (PE), wherein the device (1) comprises
-- a determining unit (2) for determining a differential current depending on a phase conductor current in the phase conductor (Lx) and a neutral conductor current in the neutral conductor (N),
**characterized in that** the device additionally comprises:
-- a computing unit (4) for determining a frequency spectrum of the differential current,
-- an amplifier (6) connected to the computing unit (4) or a digital-to-analogue converter connected to the computing unit (4) for generating a compensation current from an unamplified compensation current signal generated by the computing unit (4) based on the frequency spectrum determined and a predefined phase shift and
-- an infeed unit (11) for feeding the compensation current into the phase conductor (Lx) and/or into the neutral conductor (N), said compensation current compensating for a leakage current caused by the differential current.

8. Charging device for charging an electrical energy store with an electricity network (10) and a device according to Claim 7.

9. Charging device according to Claim 8, **characterized in that** the charging device is configured as a galvanically non-isolated charging device.

## Revendications

1. Procédé de réduction des courants de fuite dans un conducteur de protection (PE) d'un réseau électrique (10) qui comprend en plus du conducteur de protection (PE) un conducteur neutre (N) et un conducteur de phase (Lx), dans lequel un courant différentiel est déterminé en fonction d'un courant de conducteur de phase dans le conducteur de phase (Lx) et d'un courant de conducteur neutre dans le conducteur neutre (N), et dans le conducteur de phase (Lx) et/ou dans le conducteur neutre (N) est alimenté un courant de compensation qui compense un courant de fuite provoqué par le courant différentiel,
**caractérisé en ce qu'**un spectre de fréquences du courant différentiel déterminé est déterminé, et le courant de compensation est généré en fonction du spectre de fréquences déterminé et d'un décalage de phases prédéfini.

2. Procédé selon la revendication 1, **caractérisé en ce que** le courant différentiel est déterminé au moyen d'un transformateur de courant différentiel (2).

3. Procédé selon l'une quelconque des revendications précédentes, **caractérisé en ce que** le courant différentiel déterminé est transformé en courant différentiel numérique au moyen d'un convertisseur analogique/numérique (3).

4. Procédé selon l'une quelconque des revendications précédentes, **caractérisé en ce que** le courant de compensation est alimenté par un couplage capacitif.

5. Procédé selon l'une quelconque des revendications 1 à 3, **caractérisé en ce que** le courant de compensation est alimenté par un couplage inductif.

6. Procédé selon l'une quelconque des revendications 1 à 3, **caractérisé en ce que** le courant de compensation est alimenté par un couplage galvanique.

7. Dispositif de réduction des courants de fuite dans un conducteur de protection (PE) d'un réseau électrique (10) qui comprend en plus du conducteur de protection (PE) un conducteur neutre (N) et un conducteur de phase (Lx), le dispositif (1) présentant :
- un dispositif de détermination (2) pour déterminer un courant différentiel en fonction d'un courant de conducteur de phase dans le conducteur de phase (Lx) et d'un courant de conducteur neutre dans le conducteur neutre (N),
**caractérisé en ce que** le dispositif présente en outre :
- une unité de calcul (4) pour déterminer un spectre de fréquences du courant différentiel,
- un amplificateur (6) relié à l'unité de calcul (4) ou un convertisseur numérique/analogique relié à l'unité de calcul (4) pour générer un courant de compensation à partir d'un signal de courant de compensation non amplifié, généré par l'unité de calcul (4) à l'aide du spectre de fréquences déterminé ainsi que d'un décalage de phases prédéfini, et
- un dispositif d'alimentation (11) pour alimenter le courant de compensation dans le conducteur de phase (Lx) et/ou dans le conducteur neutre (N) qui compense un courant de fuite provoqué par le courant différentiel.

8. Dispositif de charge pour charger un accumulateur d'énergie électrique par un réseau électrique (10) et un dispositif selon la revendication 7.

9. Dispositif de charge selon la revendication 8, **caractérisé en ce que** le dispositif de charge est configuré sous la forme d'un dispositif de charge sans isolation galvanique.
